# EUROPEAN PATENT SPECIFICATION

(11) **EP 3 615 442 B1**
(45) Date of publication and mention of the grant of the patent: **03.12.2025**
(21) Application number: 18790961.9
(22) Date of filing: 25.04.2018
(51) Int. Cl.: G01S 5/02, B65D 25/20, B64D 45/00, H02J 7/00, H02J 7/34, H01M 16/00, H01M 10/44, H01M 10/42, H01M 10/24, H01M 4/06, H01M 4/42, H03K 5/24

(54) **EMERGENCY LOCATING TRANSMITTER WITH ALKALINE BATTERY AND SUPERCAPACITOR POWER SUPPLY**
NOTFALLORTUNGSSENDER MIT ALKALIBATTERIE UND SUPERKONDENSATORSTROMVERSORGUNG
ÉMETTEUR DE LOCALISATION D'URGENCE AVEC BATTERIE ALCALINE ET ALIMENTATION ÉLECTRIQUE DE SUPERCONDENSATEUR

(30) Priority: 27.04.2017 US 201762490692 P
(43) Date of publication of application: 04.03.2020
(73) Proprietor: ACR ELECTRONICS, INC., Fort Lauderdale, FL 33312 (US)
(72) Inventor: COX, William, Sunrise, Florida 33323 (US); JOHNSON, Isaac, Fort Lauderdale, Florida 33312 (US); GORA, Irek, Fort Lauderdale, Florida 33312 (US)
(74) Representative: Mozzi, Matteo
(86) International application number: PCT/US2018/029337
(87) International publication number: WO 2018/200659

(56) References cited:
- EP-A1- 3 144 694
- WO-A1-2011/010942
- WO-A2-2008/085503
- CN-A- 104 916 854
- US-A1- 2008 315 829
- US-A1- 2015 042 470
- US-A1- 2015 134 154
- US-A1- 2016 138 550

## Description

This application claims priority to co-pending U.S. Provisional Application No. 62/490,692 filed on April 27, 2017.

### 1. Field of the Invention

This invention relates to a safe DC power supply for an emergency locator transmitter (ELT) installed in a commercial aircraft, eliminating the use of lithium batteries on board the aircraft.

### 2. Description of Related Art

Emergency locator transmitters (ELTs) are well known in the prior art. The device has its own independent battery power supply and is mounted in an aircraft and if the aircraft crashes, the device will transmit an emergency signal to its surroundings including satellites with information concerning the location of the aircraft at the crash site.

Commercial jet aircraft are subject to extremely low temperatures while flying at high altitudes. Lithium batteries have been utilized in the past in ELTs as a suitable power supply because lithium batteries operate satisfactorily at low temperatures. However there have been incidents of lithium battery fires from self-igniting and exploding, undesirable events in an aircraft. Alkaline batteries have been deficient as a power supply for ELTs because of their poor performance in extremely cold environments.

The device described in this invention overcomes the inherent problems previously found in using an alkaline battery in an ELT by providing an improved ELT power supply that includes alkaline batteries and supercapacitor networks that can safely and efficiently supply power to an ELT when necessary, regardless of temperature extremes on board an aircraft.

EP 3144694 A1 relates to aircraft distress tracking and interface to search and rescue system.

CN 104916854 A relates to an alkaline zinc-manganese battery capable of improving large power/current pulse discharge performance.

US 2016/138550 A1 relates to a method to decouple battery from high level cranking currents of diesel engines.

WO 2008/085503 A2 discloses wireless powering of devices, namely cell phones and the like, with a power harvester.

### SUMMARY OF THE INVENTION

An independent D.C. power supply for a conventional emergency locator transmitter (ELT) for use in an aircraft for locating the position of an aircraft in the event of a crash. The ELT typically includes an RF transmitter, an antenna connected to said transmitter, a secure housing for said transmitter, a CPU connected to said transmitter, and an accelerometer connected to said CPU for activating said transmitter in the event of a crash.

The ELT is powered by its own D.C. power source that in accordance with the invention includes alkaline batteries and supercapacitors that together provide DC power for an ELT arming circuit and a self-test circuit, and DC power for an emergency ON mode due to a crash or manual activation. An alkaline battery pack 12V output is connected to a supercapacitor network board. The supercapacitors are charged when the ELT is activated ON using a comparator network. Supercapacitors provide power to the ELT through a D.C. boost with D.C. pass through when the ELT is activated ON, either from a crash or manual turn on.

The device uses two voltage levels by way of voltage taps on the battery pack; one 6V voltage level is for self-test and arming or standby and one voltage level is to charge the supercapacitors when the ELT unit is turned ON.

The battery pack output includes a six volt tap to a distribution switch to power the ELT in the armed mode (standby) and self- test.

It is an object of this invention to provide an improved DC power supply for an ELT mounted on an aircraft that does not require lithium batteries, but instead uses conventional alkaline batteries in conjunction with a supercapacitor network to provide a reliable power source even when the unit is subjected to extreme temperatures that can affect the alkaline battery operation.

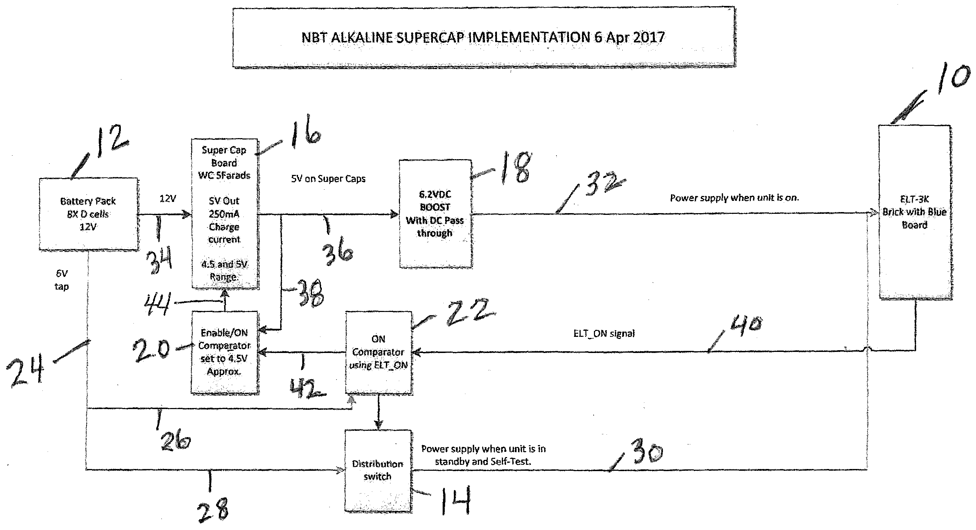

### BRIEF DESCRIPTION OF THE DRAWING

The drawing shows a circuit diagram of the D.C. power supply for an ELT using an alkaline battery pack and supercapacitors in accordance with the invention.

### DETAILED DESCRIPTION OF THE INVENTION

Referring now to the drawing, an ELT DC power supply is shown in accordance with the invention for a conventional ELT 10 that could be permanently mounted in a commercial aircraft such as a Boeing 737 for emergency use. The ELT DC power supply includes an alkaline battery pack 12 that can include 8 "D" cells of 1.5 V each, for a total of 12 V from the battery pack 12.

The DC power supply circuitry includes a distribution switch 14.

The ELT 10 has two modes of operation. The ARMED mode is the normal configuration during a conventional flight. No emergency RF signals are transmitted from the ELT in the ARMED configuration. The distribution switch 14 provides for a 6 V tap from the battery pack 12 through circuit 24 and circuit 28 to the ELT 10 which is the power supply for the ARMED mode and also provides for self-test through circuit 30 which provides power supply when the ELT is in standby and self-test modes.

The power supply shown in the drawing is controlled by the activation of the ELT ON and the distribution switch 14 and functions differently in different modes.

The battery pack 12 has a 6 V tap output wire 24 and 28 to the distribution switch 14 that supplies power to the ELT when the unit is ARMED and for self-test. The battery pack 12 also provides a 6 V tap to comparator 22 through circuit 24 and circuit 26. In the ARMED configuration, the super capacitors on the supercapacitor board 16 are not charged in the ARMED mode.

In the event of a crash, the accelerometer circuitry in ELT 10 will turn ON, sending an ON signal through circuits 40 and 42 to comparator 22. ON comparator through circuit 42 will enable comparator 20 to send voltage to the supercapacitors on supercapacitor board 16 through circuit 44 charging the supercapacitors between 4.5 and 5 V. Comparator is an enable/on switch set to approximately 4.5 V. The super capacitor board 16 has WC 5 Farads with a 5 V output and 250 mA charge current in a 4.5 and 5 volt range. The charged supercapacitors 16 will then provide power through a 6.2 DC boost with DC pass through element 18 and circuits 36 and 32 to supply the power necessary for the ELT 10 to transmit emergency RF signals that give position location of the crash. Circuit 32 represents the power supply when the ELT is on. Note that the ELT 10 can also be manually turned ON to the emergency transmit mode by the pilot in the cockpit. Circuit 38 provides voltage to comparator 20.

The use of two voltage sources enables an active system to fail and still be able to operate adding redundancy. Low current charging rate and hysteresis allow the extraction of more energy during times when the internal resistances of batteries increase such as extreme temperatures and low charge level. Batteries are buffered from the ELT unit in activated state.

Using the invention described herein, an ELT can be safely operated and dependably operated using alkaline batteries which can replace lithium batteries without a degradation of performance and dependability.

## Claims

1. A D.C. power supply for an emergency locator transmitter, ELT, (10) for an aircraft comprising:
at least one alkaline battery (12);
a super capacitor board (16) having a DC power input connected to said at least one alkaline battery (12) and a DC discharge output;
a distribution switch (14) connected to said at least one alkaline battery (12) and connectable to said ELT arming switch for arming said ELT;
an ON comparator (22) connected to said at least one alkaline battery (12) to said super capacitor output into said ELT ON switch, said ON comparator (22) being configured to receive an ON signal from said ELT, said ON comparator generating an output signal in response to receipt of said ON signal to send voltage to the supercapacitor board (16) to charge supercapacitors on the supercapacitor board (16);
a voltage boost with DC pass through element (18) connected to the output of said super capacitor board (16) and to the input of said ELT activation circuitry;
whereby when said ELT on switch is activated, activation power is provided to said ELT (10) by said super capacitor output via said boost output.

2. A D.C. power supply as in claim 1 including:
a voltage tap connected to the output of said at least one alkaline battery (12) providing voltage to said distribution switch (14) to provide power for the ELT armed mode and self-test mode.

3. A method of providing D. C. power to an emergency locator transmitter, ELT, (10) located on an aircraft using a power supply having alkaline batteries (12) comprising the steps of:
a) providing an alkaline battery power supply for an ELT mounted on an aircraft;
b) providing said ELT (10) with three modes of operation including off, armed, and on;
c) providing a power distribution switch (14) connected to said battery power supply and said ELT armed mode switch;
d) providing a supercapacitor board (16) having a DC power input connected to the alkaline battery power supply and a DC discharge output;
e) providing a comparator (22) connected to said voltage supply output and to the on mode switch of said ELT (10) and having an output connected to said super capacitor for charging said super capacitor;
f) providing a voltage boost with DC pass through (18) connected to the output of said super capacitor and to the input of said ELT (10) on mode switch;
whereby when said ELT (10) is switched on, comparator (22) turns on and provides voltage to charge said super capacitor through voltage from said alkaline battery power supply and providing output voltage through said voltage boost (18) to power said ELT (10).

## Patentansprüche

1. Eine Gleichstromversorgung für einen Notfallortungssender, ELT, (10) für ein Luftfahrzeug, umfassend:
mindestens eine Alkalibatterie (12);
eine Superkondensatorplatine (16) mit einem Gleichstromeingang, der mit der mindestens einen Alkalibatterie (12) verbunden ist, und einem Gleichstromausgang zur Entladung;
einen Verteilungsschalter (14), der mit der mindestens einen Alkalibatterie (12) verbunden ist und mit dem ELT-Schalter zur Scharfschaltung des ELT verbindbar ist;
einen Einschaltsignal-Komparator (22), der mit der mindestens einen Alkalibatterie (12), dem Ausgang des Superkondensators und dem Einschalter des ELT verbunden ist, wobei der Einschaltsignal-Komparator (22) so konfiguriert ist, dass er ein Einschaltsignal vom ELT empfängt und als Reaktion auf den Empfang dieses Einschaltsignals ein Ausgangssignal erzeugt, um Spannung an die Superkondensatorplatine (16) zu senden, um die Superkondensatoren auf der Superkondensatorplatine (16) zu laden;
eine Spannungserhöhungseinheit mit Gleichstromdurchgangselement (18), die mit dem Ausgang der Superkondensatorplatine (16) und dem Eingang der ELT-Aktivierungsschaltung verbunden ist;
wodurch, wenn der ELT-Einschalter aktiviert wird, die Aktivierungsspannung dem ELT (10) über den Ausgang des Superkondensators über den Spannungsausgang bereitgestellt wird.

2. Eine Gleichstromversorgung gemäß Anspruch 1, umfassend:
einen Spannungspunkt, der mit dem Ausgang der mindestens einen Alkalibatterie (12) verbunden ist und Spannung an den Verteilungsschalter (14) liefert, um Energie für den scharfen Modus und den Selbsttestmodus des ELT bereitzustellen.

3. Ein Verfahren zur Bereitstellung von Gleichstrom für einen Notfallortungssender, ELT, (10), der sich an Bord eines Luftfahrzeugs befindet und eine Stromversorgung mit Alkalibatterien (12) verwendet, umfassend die Schritte:
a) eine Alkalibatterie-Stromversorgung für ein auf einem Luftfahrzeug montiertes ELT bereitzustellen;
b) dem ELT (10) drei Betriebsmodi bereitzustellen, einschließlich aus, scharf und ein;
c) einen Energieverteilungsschalter (14) bereitzustellen, der mit der Batterieversorgung und dem Scharfmodus-Schalter des ELT verbunden ist;
d) eine Superkondensatorplatine (16) bereitzustellen, mit einem Gleichstromeingang, der mit der Alkalibatterieversorgung verbunden ist, und einem Gleichstromausgang zur Entladung;
e) einen Komparator (22) bereitzustellen, der mit dem Spannungsausgang und dem Einschalter des ELT (10) verbunden ist und einen Ausgang aufweist, der mit dem Superkondensator verbunden ist, um diesen aufzuladen;
f) eine Spannungserhöhungseinheit mit Gleichstromdurchgang (18) bereitzustellen, die mit dem Ausgang des Superkondensators und dem Eingang des Einschaltmodus-Schalters des ELT (10) verbunden ist;
wodurch, wenn das ELT (10) eingeschaltet wird, der Komparator (22) aktiviert wird und Spannung bereitstellt, um den Superkondensator durch Spannung aus der Alkalibatterieversorgung aufzuladen, und eine Ausgangsspannung über die Spannungserhöhungseinheit (18) bereitgestellt wird, um das ELT (10) mit Energie zu versorgen.

## Revendications

1. Une alimentation en courant continu pour un émetteur de localisation d'urgence, ELT, (10) pour un aéronef, comprenant :
au moins une pile alcaline (12) ;
une carte de supercondensateur (16) ayant une entrée d'alimentation en courant continu connectée à ladite au moins une pile alcaline (12) et une sortie de décharge en courant continu ;
un commutateur de distribution (14) connecté à ladite au moins une pile alcaline (12) et pouvant être connecté au commutateur d'armement de l'ELT pour armer ledit ELT ;
un comparateur d'activation (22) connecté audit au moins un pile alcaline (12) à ladite sortie de supercondensateur dans ledit commutateur d'activation de l'ELT, ledit comparateur d'activation (22) étant configuré pour recevoir un signal d'activation en provenance dudit ELT, ledit comparateur d'activation générant un signal de sortie en réponse à la réception dudit signal d'activation afin d'envoyer une tension à la carte de supercondensateur (16) pour charger les supercondensateurs de la carte de supercondensateur (16) ;
un dispositif d'amplification de tension avec élément de passage en courant continu (18) connecté à la sortie de ladite carte de supercondensateur (16) et à l'entrée du circuit d'activation dudit ELT ;
de telle sorte que, lorsque ledit commutateur d'activation de l'ELT est activé, la puissance d'activation est fournie audit ELT (10) par ladite sortie de supercondensateur via ladite sortie d'amplification.

2. Une alimentation en courant continu selon la revendication 1 comprenant :
un point de prélèvement de tension connecté à la sortie de ladite au moins une pile alcaline (12) fournissant une tension audit commutateur de distribution (14) pour fournir de l'énergie au mode armé de l'ELT et au mode d'autotest.

3. Un procédé pour fournir de l'énergie en courant continu à un émetteur de localisation d'urgence, ELT, (10), situé sur un aéronef au moyen d'une alimentation comportant des piles alcalines (12), comprenant les étapes de :
a) fournir une alimentation par pile alcaline pour un ELT monté sur un aéronef ;
b) fournir audit ELT (10) trois modes de fonctionnement comprenant arrêt, armé et activé ;
c) fournir un commutateur de distribution d'énergie (14) connecté audit bloc d'alimentation par piles et audit commutateur de mode armé de l'ELT ;
d) fournir une carte de supercondensateur (16) ayant une entrée d'alimentation en courant continu connectée au bloc d'alimentation par pile alcaline et une sortie de décharge en courant continu ;
e) fournir un comparateur (22) connecté à ladite sortie d'alimentation en tension et au commutateur de mode activé dudit ELT (10) et ayant une sortie connectée audit supercondensateur pour charger ledit supercondensateur ;
f) fournir un dispositif d'amplification de tension avec passage en courant continu (18) connecté à la sortie dudit supercondensateur et à l'entrée du commutateur de mode activé dudit ELT (10) ;
de telle sorte que, lorsque ledit ELT (10) est activé, le comparateur (22) s'active et fournit une tension pour charger ledit supercondensateur au moyen de la tension provenant dudit bloc d'alimentation par pile alcaline et fournit une tension de sortie par l'intermédiaire dudit dispositif d'amplification de tension (18) pour alimenter ledit ELT (10).
